(19) **Europäisches Patentamt**
**European Patent Office**
**Office européen des brevets**

(11) **EP 4 505 572 B1**

(12) **EUROPÄISCHE PATENTSCHRIFT**

(45) Veröffentlichungstag und Bekanntmachung des Hinweises auf die Patenterteilung:
**15.10.2025 Patentblatt 2025/42**

(21) Anmeldenummer: **23726852.9**

(22) Anmeldetag: **25.04.2023**

(51) Internationale Patentklassifikation (IPC):
**H02J 7/00** (2006.01)  **G01R 31/388** (2019.01)

(52) Gemeinsame Patentklassifikation (CPC):
**H02J 7/0016; G01R 31/392; H02J 7/007182**

(86) Internationale Anmeldenummer:
**PCT/DE2023/100298**

(87) Internationale Veröffentlichungsnummer:
**WO 2023/208282 (02.11.2023 Gazette 2023/44)**

(54) **VERFAHREN ZUM AUFLADEN EINES WIEDERAUFLADBAREN ENERGIESPEICHERS**

METHOD FOR CHARGING A RECHARGEABLE ENERGY STORAGE DEVICE

PROCÉDÉ DE RECHARGE D'UN ACCUMULATEUR D'ÉNERGIE RECHARGEABLE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **25.04.2022 DE 102022109869**

(43) Veröffentlichungstag der Anmeldung:
**12.02.2025 Patentblatt 2025/07**

(73) Patentinhaber: **Benning CMS Technology GmbH 79232 March (DE)**

(72) Erfinder: **WOLFRAM, Walter 79427 Eschbach (DE)**

(74) Vertreter: **Geitz Patentanwälte PartG mbB Werthmannstrasse 15 79098 Freiburg (DE)**

(56) Entgegenhaltungen:
**EP-A1- 0 998 779       EP-B1- 0 998 779
US-A- 5 952 815       US-A1- 2013 314 033
US-A1- 2017 279 283**

**EP 4 505 572 B1**

## Beschreibung

Die Erfindung betrifft ein Verfahren zum Laden eines wiederaufladbaren Energiespeichers, wobei der Energiespeicher mindestens einen Zellblock mit einer Anzahl J von in Reihe geschalteten Batteriezellen aufweist.

Ein Energiespeicher umfasst mehrere in Reihe und/ oder parallel geschaltete galvanische Zellen, die als Batteriezellen bezeichnet werden. Bei der Entladung der Batteriezellen wird gespeicherte chemische Energie in elektrische Energie umgewandelt. Diese elektrische Energie kann von einem Verbraucher genutzt werden, der vom elektrischen Stromnetz unabhängig ist, beispielsweise von einem Elektrofahrzeug. Darüber hinaus kann die elektrische Energie des Energiespeichers von einem Verbraucher genutzt werden, der in ein Stromnetz eingebunden ist, um eine Unterbrechung der Stromversorgung durch das Stromnetz zu überbrücken. Der mit wiederaufladbaren Batteriezellen ausgestattete Energiespeicher wird nach einer Entladung wieder aufgeladen, um für den erneuten Einsatz zur Verfügung zu stehen.

Bei Energiespeichern (Akkumulatoren), die aus mehreren seriell miteinander verbundenen wiederaufladbaren Batteriezellen bestehen, ist es unter anderem für die Lebensdauer des Energiespeichers wichtig, dass jede einzelne Zelle weder beim Aufladen des Energiespeichers überladen noch beim Entladen zu tief entladen wird und alle Zellen möglichst den gleichen Ladezustand aufweisen. Dieses gilt insbesondere für Energiespeicher, die aus mehreren seriell miteinander verbundenen Lithium-Ionen-Batterien, Lithium-Polymer-Batterien und/oder Lithium-Eisen-Phosphat-Batterien bestehen.

In einer Reihenschaltung der Batteriezellen werden alle Batteriezellen von dem gleichen Ladestrom durchflossen. Da Batteriezellen unterschiedliche Innenwiderstände oder Wirkungsgrade aufweisen können, sind die Verlustleistungen der einzelnen Batteriezellen beim Laden unterschiedlich. Dies führt dazu, dass nicht alle Batteriezellen nach dem Laden die gleiche Kapazität aufweisen, die für ein späteres Entladen genutzt werden kann. Diese Kapazität wird auch als Nutzkapazität bezeichnet. Die Batteriezelle mit dem größten Innenwiderstand oder dem schlechtesten Wirkungsgrad weist nach Abschluss des Aufladens des Zellblocks die geringste Nutzkapazität auf, da bei ihr die Verlustleistung am größten ist. Dies führt bei anschließendem Entladen dazu, dass diese Zelle am weitesten entladen wird. Sie ist also die Batteriezelle mit dem höchsten Depth of Discharge DoD im Zellblock. Je höher aber der DoD einer Zelle, umso niedriger die Lebensdauer dieser Zelle. Dies führt für diese eine Zelle zu einer überproportionalen Alterung und damit zum vorzeitigen Ausfall des Zellblocks.

Zur Bestimmung des jeweiligen Ladezustandes einer Batteriezelle kann deren jeweilige Zellspannung gemessen und dann beim Über- oder Unterschreiten vorgegebener Zellspannungswerte gegebenenfalls ein Ladungsausgleich zwischen den Batteriezellen des Zellblocks erfolgen, sofern die Batteriezellen unterschiedliche Ladezustände aufweisen. Dabei tritt allerdings das Problem auf, dass die Zellspannung zumindest abschnittsweise während des jeweiligen Ladevorganges einer Batteriezelle weitgehend konstant bleibt, so dass es schwierig ist, aus der Zellspannung auf den augenblicklichen Ladezustand der entsprechenden Batteriezelle zu schließen. Lediglich kurz vor Erreichen der jeweiligen Lade- bzw. Entladeschlussspannung ergibt sich ein relativ starker Anstieg bzw. Abfall der jeweiligen Zellspannung, der für entsprechende Regelungsvorgänge für einen Ladungsausgleich herangezogen werden kann.

Diese Ausgleichsvorgänge benötigen allerdings sehr viel Zeit. **In** dieser Zeit ist der Batterieblock nicht für den Normalbetrieb einsetzbar.

**In** der Regel sind derartige Energiespeicher daher jeweils mit einer häufig auch als Batteriemanagement-System bezeichneten Vorrichtung verbunden, die einerseits mittels einer Ladekontrolleinrichtung den Ladezustand der einzelnen Batteriezellen ständig überwacht und andererseits versucht, bei unterschiedlichen Ladezuständen der einzelnen Batteriezellen diese auszugleichen. Dabei kann der auch als Balancing bezeichnete Ausgleich der Ladezustände der Batteriezellen durch passives oder aktives Balancing erfolgen. Außerdem beginnt bei den bekannten Batteriemanagementsystemen der Ladungsausgleich erst, wenn mindestens eine der Batteriezellen voll geladen ist, so dass der gesamte Ladevorgang eines Zellblockes relativ zeitaufwendig ist.

Bei dem passiven Balancing wird bei derjenigen Batteriezelle, die ihre Ladeschlussspannung als erstes erreicht hat, die überschüssige Energie über einen Widerstand in Wärme umgewandelt und geht damit für den Ladevorgang verloren.

Bei dem aktiven Balancing wird hingegen die Energie, die man einer Batteriezelle mit zu hoher Zellspannung entnimmt, nicht in thermische Energie umgewandelt, sondern zum Laden der anderen Zellen des Energiespeichers verwendet. Allerdings beginnt auch bei dem aktiven Balancing der Ladungsausgleich erst wenn mindestens eine der Batteriezellen des Zellblockes ihre Ladeschlussspannung erreicht hat.

Aus der DE 10 2017 009 850 A1 ist ein Verfahren zum Laden und Entladen eines Energiespeichers mit mindestens einem Zellblock aus mehreren in Reihe geschalteten Batteriezellen ohne aktives oder passives Balancing bekannt. Bei diesem bekannten Verfahren erreichen alle Batteriezellen gleichzeitig ihre Ladeschlussspannung oder Entladeschlussspannung. Hierzu wird unter Berücksichtigung eines vorgegebenen C-Faktors, welcher dem Quotient von maximalem Ladestrom $I_{N;max}$ zur Kapazität $C_N$ jeder der Batteriezellen entspricht, aus der Kapazität $C_N$ jeder Batteriezellen ihr charakteristischer maximaler Ladestrom $I_{N;max}$ bestimmt. Während einer vorgegebenen Zeit t, welche kleiner oder gleich dem Kehrwert des C-Faktors ist, werden alle Batteriezellen gleichzeitig mit den ihnen jeweils zugeordneten maximalen Ladeströmen $I_{N;max}$ geladen. Die Differenz zwischen dem zur Verfügung stehenden Ladestrom $I_0$ und dem maximalen Ladestrom $I_{N;max}$ einer Batteriezelle wird über Hilfs-Lade-/Entladeeinrichtungen als Hilfs-Ladestrom von dem Zellblock entnommen oder diesem zugeführt. Das Entladen erfolgt entsprechend.

Aus der DE 10 2019 129 415 B3 ist ein Verfahren zum Aufladen und/ oder Entladen eines wiederaufladbaren Energiespeichers mit einem Strom $I_0$ bekannt, wobei der Energiespeicher mindestens einen Zellblock mit einer Anzahl J von in Reihe geschalteten Batteriezellen umfasst und mindestens einige der Batteriezellen unterschiedliche Wirkungsgrade $\eta_N$ mit $1 \le N \le J$ aufweisen. Dabei wird zunächst die Batteriezelle mit dem schlechtesten Wirkungsgrad $\eta_{min}$ bestimmt. Anschließend werden die Wirkungsgrade $\eta_N$ aller übrigen Batteriezellen an diesen schlechtesten Wirkungsgrad $\eta_{min}$ angeglichen, so dass für den angeglichenen Wirkungsgrad $\eta_{N'}$ der Batteriezellen gilt: $\eta_{N'} = \eta_{min}$.

Der Erfindung liegt die Aufgabe zugrunde, ein Verfahren zum Laden und Entladen eines Energiespeichers mit in Reihe geschalteten Batteriezellen ohne aktives oder passives Balancing zur Verfügung zu stellen, bei dem alle Batteriezellen gleichzeitig geladen werden und am Ende des Ladevorgangs alle Batteriezellen ihre vorgegebene Ladeschlussspannung aufweisen, und zwar insbesondere auch dann, wenn einzelne Batteriezellen unterschiedliche Ladezustände, Kapazitäten, Innenwiderstände, Wirkungsgrade oder Gesundheitszustände aufweisen, wobei auf Hilfsladeströme und Hilfsentladeströme sowie auf eine aktive Angleichung der Wirkungsgrade der Batteriezellen verzichtet werden kann.

Diese Aufgabe wird durch ein Verfahren zum Aufladen eines Energiespeichers nach Anspruch 1 gelöst. Das Verfahren zeichnet sich dadurch aus, dass bei einem Energiespeicher mit mindestens einem Zellblock mit einer Anzahl J von in Reihe geschalteten Batteriezellen, welche unterschiedliche Kapazitäten $C_n$, unterschiedliche Innenwiderstände und/ oder unterschiedliche Wirkungsgrade mit $1 \le n \le J$ aufweisen können, alle J Batteriezellen mit einem Ladestrom $I_0$ aufgeladen werden, bis eine Batteriezelle i mit $1 \le i \le J$ eine für diese Batteriezelle i vorgegebene Ladeschlussspannung $U_{i,L}$ erreicht, und dass dann für alle Batteriezellen der Ladestrom auf einen Wert $I_i$ reduziert wird, für den gilt:

$$0A < I_i < I_0.$$

Dabei ist $I_i$ ein für diese Batteriezelle i vorgegebener Ladestrom, bei dem die Zellspannung $U_i$ der Batteriezelle i nicht über die Ladeschlussspannung $U_{i,L}$ dieser Batteriezelle i ansteigt, während alle Batteriezellen weiterhin mit dem Ladestrom $I_i$ geladen werden.

Alle reduzierten Ladeströme $I_i$ führen nicht zu einem Ansteigen der Zellspannung $U_{i,L}$ der Batteriezelle i. Dennoch sorgt der Ladestrom $I_i$ dafür, dass die übrigen Batteriezellen des Zellblocks weiter geladen werden und ihre Zellspannung weiter ansteigt.

Die Zellspannung aller J Batteriezellen wird während des Aufladens kontinuierlich oder zu bestimmten Zeitpunkten bestimmt. Für jede Batteriezelle wird die erfasste Zellspannung regelmäßig mit der für die Batteriezelle vorgegebenen Ladeschlussspannung verglichen. Beispielsweise kann die Zellspannung in regelmäßigen Zeitabständen bestimmt werden. Darüber hinaus kann die Zellspannung immer dann bestimmt werden, wenn eine der Batteriezellen ihre vorgegebene Ladeschlussspannung erreicht hat.

Sobald beim Ladevorgang eine Batteriezelle i ihre Ladeschlussspannung erreicht, wird der Ladestrom von $I_0$ auf $I_i$ reduziert. Der Ladevorgang wird von konstantem Strom CC auf konstante Zellspannung Constant Cell Voltage CCV umgeschaltet, so dass in dieser Batteriezelle i die Zellspannung $U_i$ nicht weiter ansteigt. In allen anderen Batteriezellen führt das Laden mit dem reduzierten Ladestrom $I_i$ zu einer Erhöhung der Zellspannung $U_n$ mit $1 \le n \le J$ und $n \ne i$ und zu einem Ansteigen des Ladezustands.

Der Ladestrom von wird $I_i$ auf einen Ladestrom $I_j$ reduziert mit $1 \le j \le J$ und $j \ne i$ und $I_j < I_i$, wenn beim Laden der Batteriezellen mit dem Ladestrom $I_i$ eine weitere Batteriezelle j ihre vorgegebene Ladeschlussspannung erreicht, bevor das Aufladen beendet wird. Dies gilt für die Batteriezelle, die nach der Batteriezelle i als nächste ihre vorgegebene Ladeschlussspannung erreicht und auch für jede weitere Batteriezelle, die danach ihre Ladeschlussspannung erreicht, solange das Aufladen noch andauert. Das Aufladen wird erst beendet, wenn der reduzierte Ladestrom kleiner ist als ein vorgegebener Ladestrom-Schwellenwert Isw.

Da der Ladestrom von $I_0$ auf $I_i$ reduziert wird, wenn die Batteriezelle i ihre vorgegebene Ladeschlussspannung $U_{i,L}$ erreicht hat, und der Ladestrom $I_i$ kleiner ist als $I_0$, kann es beim ersten Aufladen eines Zellblocks nach dem erfindungsgemäßen Aufladen einige Zeit dauern, bis alle Batteriezellen ihre vorgegebene Ladeschlussspannung erreicht haben. Da beim anschließenden Entladen alle Batteriezellen bei ihrer vorgegebenen Ladeschlussspannung starten, werden die Batteriezellen nicht bis zu einer DoD entladen, die zu einer überproportionalen Alterung und zu einem vorzeitigen Ausfall des Zellblocks führt. Es wird davon ausgegangen, dass bei allen weiteren Ladevorgängen dieses Zellblocks die Batteriezellen nahezu gleichzeitig oder kurz nacheinander ihre vorgegebene Ladeschlussspannung erreichen, so dass bei den weiteren Ladevorgängen eine schnelle Aufladung erfolgt.

Das erfindungsgemäße Verfahren unterscheidet sich von bekannten Verfahren, bei denen der gesamte Zellblock auf eine Block-Ladeschlussspannung geladen wird. Diese Block-Ladeschlussspannung liegt in der Regel deutlich unterhalb einer Ladeschlussspannung, die sich aus der Summe der einzelnen Ladeschlussspannungen aller Zellen ergibt. Bei dem erfindungsgemäßen Verfahren wird der Zellblock so lange geladen, bis alle Batteriezellen des Zellblocks eine für sie vorgegebene Ladeschlussspannung unter Berücksichtigung einer Toleranz erreicht haben, die klein ist gegenüber der vorgegebenen Ladeschlussspannung der Zellen. Die vorgegebene Ladeschlussspannung für die J Batteriezellen des Zellblocks kann für alle Batteriezellen gleich sein. Es besteht jedoch auch die Möglichkeit, dass für verschiedene Batteriezellen unterschiedliche Ladeschlussspannungen vorgegeben werden. Die Ladeschlussspannung des Zellblocks ergibt sich auch hier aus der Summe der Ladeschlussspannungen der einzelnen Batteriezellen.

Der Ladestrom wird für alle Batteriezellen abgeschaltet, wenn der reduzierte Ladestrom $I_i$ oder $I_j$ kleiner als ein vorgegebener Ladestrom-Schwellenwert Isw ist. Anschließend wird zu jeder Batteriezelle die Zellspannung $U_n$ mit $1 \leq n \leq J$ bestimmt. Dann werden die Batteriezelle m mit der kleinsten Zellspannung $U_m = U_{min}$ und die Batteriezelle I mit der größten Zellspannung $U_I = U_{max}$ bestimmt. Mit Ausnahme der Batteriezelle m werden danach alle anderen Batteriezellen des Zellblocks über Widerstände entladen, die zu den Batteriezellen parallel geschaltet sind, bis für die Zellspannung $U_I$ der Batteriezelle I gilt $U_I = U_{min}$. Anschließend wird das erfindungsgemäße Verfahren wiederholt und es werden alle J Batteriezellen mit dem Ladestrom $I_0$ geladen, bis die Batteriezelle i als erste ihre vorgegebene Ladeschlussspannung $U_{i,L}$ erreicht und der Ladestrom auf $I_i$ reduziert wird. Das Absenken der Zellspannung aller Batteriezellen sorgt dafür, dass alle Batteriezellen beim anschließenden Laden mit gleichen oder ähnlichen Zellspannungen starten. Dieser Vorgang des Ladens und anschließenden Entladens bei ausgeschaltetem Ladestrom kann mehrfach wiederholt werden. Dies kann gegebenenfalls in immer kürzeren Intervallen durchgeführt werden. Bei jedem Zyklus nähern sich die Zellspannungen der Zellen weiter aneinander an. Die Abweichung der Ladeschlussspannung der einzelnen Zellen weicht nach mehreren Zyklen immer weniger unter den Zellen ab. Das Verfahren wird beendet, wenn die Differenz $U_{max} - U_{min}$ kleiner oder gleich einen vorgegebenen Grenzwert $\Delta U_1$ ist. Dieser Grenzwert kann beispielsweise 5mV sein.

Nach einer vorteilhaften Ausgestaltung der Erfindung wird bei Erreichen der vorgegebenen Ladeschlussspannung $U_{IL}$ der Batteriezelle i durch die Reduktion des Ladestroms auf $I_i$ beim Aufladen des Energiespeichers von konstantem Strom, auch genannt Constant Currant CC, umgeschaltet auf konstante Zellspannung der Batteriezelle i, auch genannt Constant Cell Voltage CCV. Es kommt daher im Unterschied zu bekannten Ladeverfahren auf das Erreichen der Ladeschlussspannung einer Batteriezelle anstelle der Block-Ladeschlussspannung an und darüber hinaus wird bei Erreichen dieses Ziels nicht die Blockspannung auf konstante Spannung CV gesetzt, sondern lediglich die Zellspannung derjenigen Batteriezelle, die bereits ihre vorgegebene Ladeschlussspannung erreicht hat. Alle anderen Batteriezelle werden weiterhin geladen.

Nach einer weiteren vorteilhaften Ausgestaltung der Erfindung gilt für den vorgegebenen Spannungswert $\Delta U_1$:

$$0{,}01 * U_{n,L} \leq \Delta U_1 \leq 0{,}02 * U_{n,L}$$

wobei $U_{n,L}$ die vorgegebene Ladeschlussspannung mindestens einer der J Batteriezellen ist.

Nach einer weiteren vorteilhaften Ausgestaltung der Erfindung gilt für den vorgegebenen Spannungswert $\Delta U_1$: $5\ mV \leq \Delta U_1 \leq 10\ mV$.

Nach einer weiteren vorteilhaften Ausgestaltung der Erfindung ist für alle J Batteriezellen die vorgegebene Ladeschlussspannung $U_{n,L}$ gleich und es gilt:

$$U_{n,L} = U_{n+1,L}\ \text{für}\ 1 \leq n \leq J\text{-}1$$

oder anders ausgedrückt:

$$U_{1,L} = U_{2,L} = U_{3,L} = \ldots = U_{J,L}.$$

Nach einer weiteren vorteilhaften Ausgestaltung der Erfindung ist dass der Ladestrom-Schwellenwert $I_{SW}$ für alle Batteriezellen gleich.

Nach einer weiteren vorteilhaften Ausgestaltung der Erfindung ist für jede Batteriezelle der reduzierte Ladestrom $I_{SW,n}$ vorgegeben in Abhängigkeit von einem jeder Batteriezelle zugeordneten maximalen Ladestrom $I_{n,max}$. Dabei gilt für den reduzierten Ladestrom $I_{SW,n}$:

$$0{,}01\ I_{n,max} \leq I_{SW,n} \leq 0{,}02\ I_{n,max}\ \text{mit}\ 1 \leq n \leq J.$$

Der maximale Ladestrom $I_{n;max}$ einer Batteriezelle wird unter Berücksichtigung eines vorgegebenen C-Faktors bestimmt. Dabei entspricht der C-Faktor dem Quotient aus maximalem Ladestrom $I_{n;max}$ und Kapazität $C_n$ der betreffenden Batteriezelle. Der maximale Ladestrom einer Batteriezelle und der C-Faktor werden beispielsweise von einer Kontroll- und Steuereinrichtung bestimmt.

Nach einer weiteren vorteilhaften Ausgestaltung der Erfindung entspricht der reduzierte Ladestrom $I_n$ für jede Batteriezelle zwischen 1% und 2% des Ladestroms $I_0$ und es gilt: $0{,}01\ I_0 \leq I_n \leq 0{,}02\ I_0$. Der reduzierte Ladestrom $I_n$ kann für alle Batteriezellen gleich sein. Alternativ dazu kann der reduzierte Ladestrom unterschiedlich sein.

Nach einer weiteren vorteilhaften Ausgestaltung der Erfindung wird für alle J Batteriezellen nach dem Laden des Zellblocks die Kapazität $C_n$ mit $1 \leq n \leq J$ bestimmt. Dabei weisen zunächst alle J Batteriezellen die gleiche Ladeschlussspannung unter Berücksichtigung der Toleranz ΔU1 auf. Die Ladeschlussspannung stimmt für alle Batteriezellen entweder mit ihrer vorgegebenen Ladeschlussspannung $U_{n,L}$ überein oder weicht von dieser um maximal $\Delta U_1$ ab und es gilt: $U_{n,L} - \Delta U_1 \leq U_n \leq U_{n,L}$. Ausgehend von dieser Ladeschlussspannung der Batteriezellen werden alle J Batteriezellen mit dem Entladestrom $I_0'$ entladen. Sobald eine Batteriezelle p mit $1 \leq p \leq J$ ihre vorgegebene Entladeschlussspannung $U_{p,E}$ erreicht, wird die Entladung aller Batteriezellen gestoppt und es wird die Zeit $t_E$ vom Beginn der Entladung bis zum Ende der Entladung bestimmt. Anschließend wird zu jeder Batteriezelle die Zellspannung $U_n$ mit $1 \leq n \leq J$ zum Zeitpunkt $t_E$ bestimmt. Zu der Batteriezelle p, welche als erste ihre vorgegebene Entladeschlussspannung $U_{p,E}$ erreicht hat, wird aus der Zeit $t_E$, dem Entladestrom $I_0'$, der Ladeschlussspannung $U_{p,L}$ und der Zellspannung $U_p = U_{p,E}$ die Kapazität $C_p$ bestimmt. Zu der Batteriezelle p wird die Zellspannung zwischen dem Beginn der Entladung und dem Ende der Entladung in Abhängigkeit von der Zeit als Spannungs-Zeit-Kurve vorgegeben. Auf dieser Spannungs-Zeit-Kurve der Batteriezelle p werden den Zellspannungen $U_n$; welche die Batteriezellen zum Zeitpunkt $t_E$ aufweisen, Zeiten $t_n$ zugeordnet. Aus den Zeiten $t_n$ und der Kapazität $C_p$ wird für alle verbleibenden J-1 Batteriezellen ihre Kapazität $C_n$ bestimmt, die diese beim Erreichen ihrer vorgegebenen Entladeschlussspannung aufweisen.

Nach einer weiteren vorteilhaften Ausgestaltung der Erfindung wird zu allen Batteriezellen beim Entladen die Zellspannung in Abhängigkeit von der Zeit erfasst. Für alle Batteriezellen wird die Zellspannung in Abhängigkeit von der Zeit als Spannungs-Zeit-Kurve abgespeichert.

Nach einer weiteren vorteilhaften Ausgestaltung der Erfindung wird die Kapazität $C_n$ der J Batteriezellen in bestimmten Zeitabständen bestimmt und in einem Speicher abgespeichert. Sie steht damit für Vergleiche oder zur Bestimmung des Alterungszustands der Batteriezellen zur Verfügung und kann bei Bedarf abgerufen werden.

Nach einer weiteren vorteilhaften Ausgestaltung der Erfindung ist für jede Batteriezelle die initiale Kapazität $C_{n,initial}$ mit $1 \leq n \leq J$ vorgegeben, wobei die initiale Kapazität $C_{n,initial}$ diejenige Kapazität ist, die die Batteriezelle vor der Erstinbetriebnahme aufweist. Für jede Batteriezelle wird in bestimmten Zeitabständen aus der Kapazität $C_n$ und der initialen Kapazität $C_{n,initial}$ der Zustand State of Health SoH der Batteriezelle bestimmt mit folgender Gleichung: $SoH = C_n / C_{n,initial} * 100$. Dabei kann die initiale Kapazität $C_{n,initial}$ mit dem erfindungsgemäßen Verfahren unmittelbar bei der Erstinbetriebnahme des Zellblocks bestimmt werden oder mit einem anderen Verfahren oder sie kann von einem Hersteller vorgegeben werden. Der Alterungszustand der Batteriezellen kann auf diese Weise in bestimmten Zeitabständen oder auf konkrete Anfrage bestimmt werden und steht damit jederzeit zur Verfügung. Der Zustand SoH der Batteriezellen kann in einem Speicher abgespeichert werden, so dass er zu beliebigen Zeitpunkten abgerufen werden kann.

Weitere Vorteile und vorteilhafte Ausgestaltungen der Erfindung sind der nachfolgenden Beschreibung, der Zeichnung und den Ansprüchen entnehmbar.

Zeichnung

In der Zeichnung ist ein Ausführungsbeispiel des Erfindungsgegenstandes dargestellt. Es zeigt:

Figur 1    Schaltplan eines Energiespeichers,

Figur 2    Zellspannung in Abhängigkeit von der Zeit bei drei Batteriezellen des Zellblocks des Energiespeichers gemäß Figur 1

Figur 3    Spannungs-Zeit-Diagramm der Batteriezellen eines von Figur 1 verschiedenen Energiespeichers.

Beschreibung des Ausführungsbeispiels

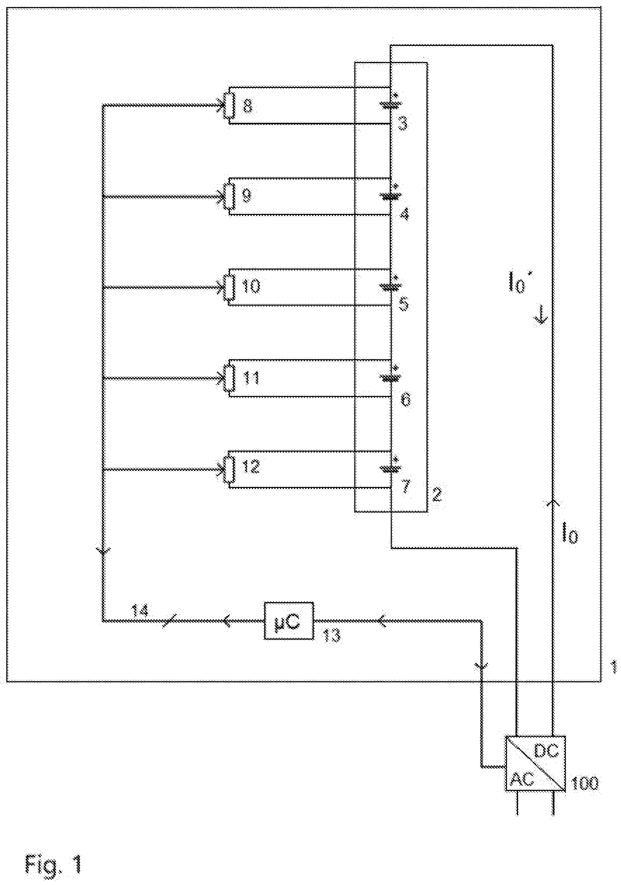

In Figur 1 ist ein Schaltplan eines Energiespeichers 1 dargestellt, der beispielsweise zur Energieversorgung eines Versorgungsnetzes eines Gebäudes dient und durch eine Anlage zur Erzeugung regenerativer Energie (Photovoltaikanlage, Windstromanlage, Biogasanlage etc.) beispielsweise über einen bidirektionalen AC/DC-Wandler 100 auf- und entladbar ist. Der Energiespeicher 1 umfasst bei dem dargestellten Ausführungsbeispiel einen Zellblock 2 mit fünf seriell miteinander verbundenen, wiederaufladbaren Batteriezellen 3, 4, 5, 6, 7. Die Anzahl J der Batteriezellen beträgt damit 5: J=5. Dabei weist

- die Batteriezelle mit n=1 die Bezugszahl 3 auf,
- die Batteriezelle mit n=2 die Bezugszahl 4 auf,
- die Batteriezelle mit n=3 die Bezugszahl 5 auf,
- die Batteriezelle mit n=4 die Bezugszahl 6 auf,
- die Batteriezelle mit n=5 die Bezugszahl 7 auf.

Jede der Batteriezellen 3 bis 7 ist mit einem schaltbaren Widerstand 8, 9, 10, 11, 12 ausgestattet. Dabei ist der schaltbare Widerstand 8 der Batteriezelle 3 parallelgeschaltet. Entsprechendes gilt für die Widerstände 9, 10, 11, 12 und die Batteriezellen 4, 5, 6, 7. Schaltbar bedeutet, dass die Widerstände für eine zeitlich begrenzte Dauer während des Ladens oder Entladens des Zellblocks zu den Batteriezellen parallel geschaltet sind.

Zur Kontrolle des Lade- bzw. Entladezustandes der einzelnen Batteriezellen 3 bis 7 ist eine Kontroll- und Speichereinrichtung 13 vorgesehen, die über entsprechende Datenleitungen 14 sowohl mit den schaltbaren Widerständen 8 bis 12 als auch mit dem bidirektionalen AC/DC-Wandler 100 verbunden ist.

Nachfolgend wird das Laden des Zellblocks 2 beschrieben:

Alle Batteriezellen 3 bis 7 im Zellblock 2 werden zunächst mit dem Ladestrom $I_0$ geladen. Die Zellspannung der Batteriezellen wird kontinuierlich erfasst. Für jede Batteriezelle wird die erfasste Zellspannung $U_n$ mit der vorgegebenen Ladeschlussspannung $U_{n,L}$ dieser Batteriezelle verglichen. Für alle Batteriezellen 3 bis 7 ist die vorgegebene Ladeschlussspannung $U_{n,L}$ gleich. Sie beträgt 4,2 V. Es gilt: $U_{1,L}=U_{2,L}=U_{3,L}=U_{4,L}=U_{5,L}= 4,2$ V. Das Aufladen aller Batteriezellen mit dem Ladestrom $I_0$ dauert an, bis eine der Batteriezellen 3 bis 7 als erste ihre vorgegebene Ladeschlussspannung erreicht. Im vorliegenden Ausführungsbeispiel ist dies die Batteriezelle mit n=2 und Bezugszahl 4. Die Batteriezelle i, die als erste ihre vorgegebene Ladeschlussspannung erreicht, ist damit die Batteriezelle 4 und es gilt i=2. Nun wird der Ladestrom auf $I_2$ reduziert, wobei gilt:

$$0A < I_2 < I_0.$$

Anschließend werden alle Batteriezellen 3 bis 7 mit dem Ladestrom $I_2$ geladen, bis die nächste Batteriezelle ihre vorgegebene Ladeschlussspannung erreicht. Im vorliegenden Ausführungsbeispiel ist dies die Batteriezelle mit n= 1 und Bezugszahl 3. Die Batteriezelle j, die als zweite ihre vorgegebene Ladeschlussspannung erreicht, ist Batteriezelle 3. Nun wird der Ladestrom auf $I_1$ reduziert, wobei gilt:

$$0A < I_1 << I_2 < I_0.$$

Anschließend wird beim Erfassen der Zellspannungen $U_n$ und dem Vergleichen der Zellspannungen $U_n$ mit den vorgegebenen Ladeschlussspannungen $U_{n,L}$ der Batteriezellen festgestellt, dass auch die übrigen Batteriezellen mit den Bezugszahlen 5, 6, 7 bereits eine Zellspannung aufweisen, die sich von ihrer vorgegebenen Ladeschlussspannung um maximal die Toleranz $\Delta U_1 = 5$ mV unterscheiden. Das Aufladen wird beendet. Die Block-Ladeschlussspannung des Zellblocks beträgt 5*4,2 V= 21 V. Dies gilt auch unter Berücksichtigung der Toleranz $\Delta U_1 = 5$ mV für die Ladeschlussspannung jeder der Batteriezellen.

Wenn festgestellt wird, dass der reduzierte Ladestrom $I_1$ kleiner ist als ein vorgegebener Ladestrom-Schwellenwert Isw, wird der Ladestrom abgeschaltet. Dann wird diejenige Batteriezelle ermittelt, die die kleinste Zellspannung aufweist. Im vorliegenden Fall ist dies die Batteriezelle 6 mit n=4. Ferner wird die Batteriezelle mit der größten Zellspannung ermittelt. Im vorliegenden Fall ist dies die Batteriezelle 4 mit n=2. Es gilt

$$U_4 < U_5 < U_3 < U_1 < U_2.$$

Dann werden die Batteriezellen 3, 4, 5 und 7 bei ausgeschaltetem Ladestrom über die ihnen zugeordneten schaltbaren Widerstände 8, 9, 10, 12 entladen, bis ihre Zellspannung mit der Zellspannung $U_4$ übereinstimmt. Dann wird der Vorgang des Ladens mit $I_0$ wie oben beschrieben wiederholt. Da bei der Wiederaufnahme des Ladens nun alle Batteriezellen bei der gleichen Zellspannung beginnen, wird davon ausgegangen, dass die vorgegebenen Ladeschlussspannungen wie oben beschrieben erreicht werden.

Das Bestimmen der Kapazitäten Cn der Batteriezellen 3 bis 7 erfolgt folgendermaßen:

Zu Beginn ist der Zellblock 2 geladen, wobei alle Batteriezellen 3 bis 7 ihre vorgegebene Ladeschlussspannung $U_n = 4,2$ V aufweisen mit $1 \leq n \leq 5$. Dann wird der Zellblock 2 mit dem Entladestrom $I_0'$ entladen. Durch die in Reihe geschalteten Batteriezellen 3 bis 7 fließt der Entladestrom $I_0'$. Während dem Entladen wird kontinuierlich oder in vorgegebenen Zeitabständen die Zellspannung $U_n$ der Batteriezellen 3 bis 7 bestimmt und mit der Entladeschlussspannung $U_{n,E}$ verglichen, die für jede der Batteriezellen vorgegeben ist. Wenn festgestellt wird, dass mindestens eine der Batteriezellen 3 bis 7 ihre vorgegebene Entladeschlussspannung erreicht hat, passiert folgendes:

- die Entladung des Zellblocks 2 wird beendet, so dass kein Entladestrom mehr fließt,
- die Zeit $t_E$ wird bestimmt, welche vom Beginn der Entladung bis zum Ende der Entladung vergangen ist,
- zu jeder Batteriezelle wird die Zellspannung $U_n(t_E)$ bestimmt, welche die Batteriezellen 3 bis 7 zum Zeitpunkt $t_E$ aufweisen,
- zu der Batteriezelle 5 mit n=3, welche als erste ihre vorgegebene Entladeschlussspannung erreicht hat, wird aus der Zeit $t_E$, dem Entladestrom $I_0'$, der Ladeschlussspannung $U_{3,L}$ der Batteriezelle 5 und der Entladeschlussspannung $U_3(t_E) = U_{3,E}$ die Kapazität $C_3$ der Batteriezelle 5 bestimmt,
- zu der Batteriezelle 5 mit n=3 wird eine Spannungs-Zeit-Kurve erstellt, indem während des Entladens von t=0 sec bis t= $t_E$ die Zellspannung in Abhängigkeit von der Zeit aufgetragen wird,
- auf dieser Spannungs-Zeit-Kurve werden den Zellspannungen $U_n(t_E)$ aller Batteriezellen außer der Batteriezelle 5 Zeiten $t_n$ zugeordnet, für die gilt $U_n(t_E) = U_3(t_n)$,
- aus den Zeiten $t_n$ und der Kapazität $C_3$ wird für die Batteriezellen 3, 4, 6, 7 die Kapazität bestimmt, die die Batteriezellen 3, 4, 6, 7 beim Erreichen ihrer vorgegebenen Entladeschlussspannung aufweisen.

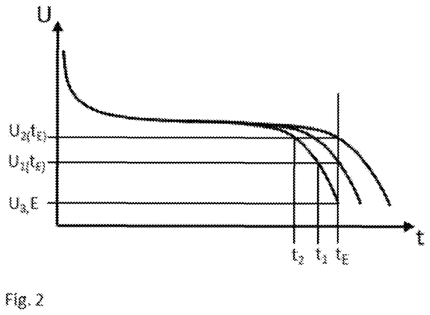

In Figur 2 sind die Spannungs-Zeit-Kurven $U_n(t)$ der Batteriezellen 3, 4 und 5 mit n=1, 2 und 3 beim Entladen des Zellblocks 2 mit dem Entladestrom $I_0'$ dargestellt. Die Spannungs-Zeit-Kurven der Batteriezellen 6 und 7 mit n=4 und n=5 sind zur Vereinfachung und zur besseren Übersichtlichkeit nicht dargestellt. Die Batteriezelle 5 mit n=3 erreicht als erste ihre vorgegebene Entladeschlussspannung $U_{3,E}$ zum Zeitpunkt t= $t_E$. Zu diesem Zeitpunkt weisen die Batteriezelle 3 mit n=1 die Zellspannung $U_1(t_E)$ und die Batteriezelle 4 mit n=2 die Zellspannung $U_2(t_E)$ auf, wobei $U_{3,E} < U_1(t_E) < U_2(t_E)$. Die beiden Batteriezellen 3, 4 mit n=1 und n=2 haben zum Zeitpunkt $t_E$ ihre Entladeschlussspannungen $U_{1,E}$ und $U_{2,E}$ noch nicht erreicht. Anhand der Spannungs-Zeit-Kurve $U_3(t)$ werden den Zellspannungen $U_1(t_E)$ und $U_2(t_E)$ Zeiten $t_1$ und $t_2$ zugeordnet, so dass gilt:

$$U_1(t_E) = U_3(t_1)$$

und

$$U_2(t_E) = U_3(t_2).$$

Aus den Spannungen $U_3(t_1)$ und $U_3(t_2)$, den Zeiten $t_1$, $t_2$ und $t_E$ und der bereits bestimmten Kapazität $C_3$ werden anschließend die Kapazitäten $C_1$ und $C_2$ berechnet, die die Batteriezellen 3, 4 mit n=1 und n=2 beim Erreichen ihrer vorgegebenen Entladeschlussspannung $U_{1,E}$ und $U_{2,E}$ aufweisen. Dabei wird davon ausgegangen, dass die Spannungs-Zeit-Kurven der Batteriezellen 3, 4 qualitativ mit der Spannungs-Zeit-Kurve der Batteriezelle 5 übereinstimmen.

Die Bestimmung der Kapazitäten der Batteriezellen 6, 7 erfolgt entsprechend.

Die auf diese Weise bestimmten Kapazitäten $C_n$ mit $1 \leq n \leq 5$ werden auch als Nutzkapazitäten bezeichnet.

Die Kapazitäten $C_1$, $C_2$, $C_3$, $C_4$ und $C_5$ werden in einem in der Zeichnung nicht dargestellten Speicher abgespeichert. In diesem Speicher sind darüber hinaus die Kapazitäten $C_{n,initial}$ abgespeichert, die jede der fünf Batteriezellen vor der Erstinbetriebnahme aufwies. Dies initiale Kapazität ist für jede der Batteriezellen vorgegeben. Anhand der Gleiche SoH = $C_n / C_{n,initial}$ * 100 wird für jede der fünf Batteriezellen der Alterungszustand SoH bestimmt und abgespeichert.

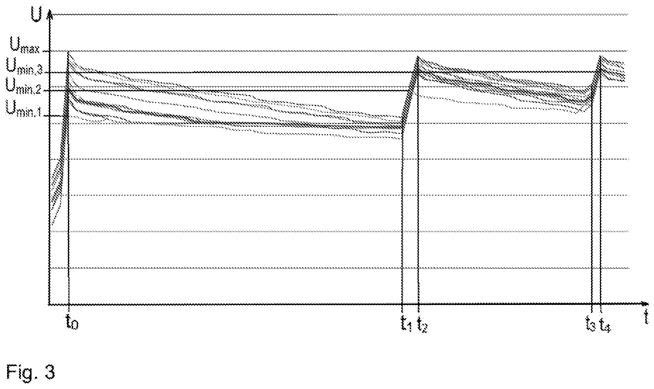

Figur 3 zeigt zwei Zyklen des Entladens und anschließenden Ladens eines Zellblocks mit mehreren in Reihe geschalteten Zellen. Die Anzahl der Zellen ist größer als bei dem in Figur 1 dargestellten Zellblock 2. Der Aufbau des Zellblocks ist jedoch ansonsten entsprechend zu dem in Figur 1 dargestellten Zellblock 2. In dem Schaubild gemäß Figur 3 ist zu den einzelnen Zellen des Zellblocks die Zellspannung U in Abhängigkeit von der Zeit t aufgetragen. Zum Zeitpunkt $t_0$ wird in einem ersten Zyklus das Laden beendet und der Ladestrom $I_0$ ausgeschaltet: $I_0$=0A. Es wird davon ausgegangen, dass zuvor mindestens eine Zelle ihre vorgegebene Ladeschlussspannung $U_{n,L}$ erreicht hat, dass daraufhin mindestens einmal der Ladestrom reduziert wurde und dass der reduzierte Ladestrom $I_i$ oder $I_j$ kleiner als ein vorgegebener Ladestrom-Schwellenwert ist. Zum Zeitpunkt $t_0$ hat die Zelle m mit der kleinsten Zellspannung die Spannung

$U_m = U_{min}$ und die Zelle I mit der größten Zellspannung die Spannung $U_I = U_{max}$. Da es sich um die kleinste Zellspannung im ersten Zyklus handelt, wird sie als $U_{min,1}$ bezeichnet. Ab dem Zeitpunkt $t_0$ werden mit Ausnahme der Zelle m alle übrigen Zellen bei ausgeschaltetem Ladestrom über Widerstände entladen, welche den Zellen parallelgeschaltet sind. Die den Zellen parallelgeschalteten Widerstände entsprechen der Darstellung in Figur 1. Das Entladen der Zellen dauert von $t_0$ bis $t_1$. In diesem Zeitraum sinkt die Zellspannung der Zellen. Das Entladen wird zum Zeitpunkt $t_1$ beendet, wenn die Zellspannung der Zelle I $U_{min,1}$ entspricht: $U_I = U_{min,1}$. Zu diesem Zeitpunkt liegt die Zellspannung $U_n$ der Zellen in einem Bereich $U_n \leq U_{min,1}$. Zum Zeitpunkt $t_1$ wird der Ladestrom $I_0$ wieder eingeschaltet und die Zellen werden wieder geladen, bis zum Zeitpunkt $t_2$, zu dem mindestens eine Zelle erneut ihre Ladeschlussspannung erreicht hat, der Ladestrom mindestens einmal reduziert wurde und der reduzierte Ladestrom $I_i$ oder $I_j$ kleiner als ein vorgegebener Ladestrom-Schwellenwert Isw ist. Zum Zeitpunkt $t_2$ wird der Ladestrom wieder ausgeschaltet. Der erste Zyklus, der von $t_0$ bis $t_2$ dauert, ist abgeschlossen. Zum Zeitpunkt $t_2$ weist die Zelle mit der kleinsten Zellspannung die Spannung $U_{min,2}$ auf. Diese Spannung ist größer als die Zellspannung $U_{min,1}$ zu Beginn des ersten Zyklus. Es gilt $U_{min,2} > U_{min,1}$. Vom Zeitpunkt $t_2$ bis zum Zeitpunkt $t_3$ werden die Zellen bis auf die Zelle mit der kleinsten Zellspannung bei ausgeschaltetem Ladestrom über die ihnen parallel geschalteten Widerstände wieder entladen, bis zum Zeitpunkt $t_3$, wenn die Zellspannung der Zelle I $U_{min,2}$ entspricht: $U_I = U_{min,2}$. Dann wird der Ladestrom wieder eingeschaltet und die Zellen werden wieder bis zum Zeitpunkt $t_4$ geladen. Zum Zeitpunkt $t_4$ weist die Zelle mit der kleinsten Zellspannung die Spannung $U_{min,3}$ auf. Diese Spannung ist größer als die Zellspannung $U_{min,2}$ und $U_{min,1}$ zu Beginn des ersten und zweiten Zyklus. Es gilt $U_{min,3} > U_{min,2} > U_{min,1}$. Der zweite Zyklus dauert von $t_2$ bis $t_4$. Die Darstellung gemäß Figur 3 zeigt folgendes:

- die Zellspannung $U_{min}$ wird von Zyklus zu Zyklus größer, so dass der Unterschied zwischen der Ladeschlussspannung $U_{max}$ der Zelle mit der größtem Zellspannung und $U_{min}$ immer kleiner wird. Die Wiederholung der Zyklen kann beendet werden, wenn sich die Zellspannungen $U_{max}$ und $U_{min}$ in einem Zyklus um weniger als einen vorgegebenen Wert unterscheiden.
- Die Dauer der Zyklen wird kürzer, da $U_{min}$ größer wird.

Sämtliche Merkmale der Erfindung können sowohl einzeln auch in beliebiger Kombination miteinander erfindungswesentlich sein.

Bezugszahlen

1 Energiespeicher
2 Zellblock
3 Batteriezelle
4 Batteriezelle
5 Batteriezelle
6 Batteriezelle
7 Batteriezelle
8 Schaltbarer Widerstand
9 Schaltbarer Widerstand
10 Schaltbarer Widerstand
11 Schaltbarer Widerstand
12 Schaltbarer Widerstand
13 Kontroll- und Speichereinrichtung
14 Datenleitung
100 bidirektionaler AC/DC-Wandler

**Patentansprüche**

1.  Verfahren zum Aufladen eines Energiespeichers (1) mit einem Ladestrom, wobei der Energiespeicher (1) mindestens einen Zellblock (2) mit einer Anzahl J von in Reihe geschalteten Batteriezellen (3, 4, 5, 6, 7) aufweist, von denen mindestens einige der Batteriezellen (3, 4, 5, 6, 7) unterschiedliche Kapazitäten $C_n$, unterschiedliche Innenwiderstände und/ oder unterschiedliche Wirkungsgrade mit $1 \leq n \leq J$ aufweisen können, mit folgenden Verfahrensschritten:

    a) Aufladen aller J Batteriezellen (3, 4, 5, 6, 7) mit einem Ladestrom $I_0$,
    b) Erfassen der Zellspannung $U_n$ aller J Batteriezellen (3, 4, 5, 6, 7), wobei die Erfassung kontinuierlich oder in vorgegebenen Zeitabständen erfolgt,
    c) Vergleichen der erfassten Zellspannung $U_n$ jeder Batteriezelle (3, 4, 5, 6, 7) mit der für diese Batteriezelle vorgegebenen Ladeschlussspannung $U_{n,L}$,
    d) sobald eine Batteriezelle i (3, 4, 5, 6, 7) mit $1 \leq i \leq J$ eine für diese Batteriezelle i (3, 4, 5, 6, 7) vorgegebene Ladeschlussspannung $U_{i,L}$ erreicht, wird für alle Batteriezellen (3, 4, 5, 6, 7) der Ladestrom auf einen Wert $I_i$ reduziert, für den gilt

    $$0A < I_i < I_0$$

    wobei $I_i$ ein für diese Batteriezelle i (3, 4, 5, 6, 7) vorgegebener Ladestrom ist, bei dem die Zellspannung Ui der Batteriezelle i (3, 4, 5, 6, 7) nicht über die Ladeschlussspannung $U_{i,L}$ ansteigt, während alle Batteriezellen (3, 4, 5, 6, 7) weiterhin mit dem Ladestrom $I_i$ geladen werden,
    e) sobald beim Laden der Batteriezellen (3, 4, 5, 6, 7) mit dem Ladestrom $I_i$ eine weitere Batteriezelle j ihre vorgegebene Ladeschlussspannung erreicht, wird der Ladestrom weiter auf einen

Ladestrom $I_j$ reduziert mit $1 \leq j \leq J$ und $j \neq i$ und $I_j < I_i$,
    f) sobald der reduzierte Ladestrom $I_i$ oder $I_j$ kleiner als ein vorgegebener Ladestrom-Schwellenwert Isw ist, wird der Ladestrom für alle Batteriezellen (3, 4, 5, 6, 7) abgeschaltet und es wird zu jeder Batteriezelle (3, 4, 5, 6, 7) die Zellspannung $U_n$ mit $1 \leq n \leq J$ bestimmt,
    g) es wird die Batteriezelle m (3, 4, 5, 6, 7) mit der kleinsten Zellspannung $U_m = U_{min}$ bestimmt und es wird die Batteriezelle l (3, 4, 5, 6, 7) mit der größten Zellspannung $U_l = U_{max}$ bestimmt,
    h) mit Ausnahme der Batteriezelle m (3, 4, 5, 6, 7) werden alle anderen Batteriezellen (3, 4, 5, 6, 7) über Widerstände (8, 9, 10, 11, 12) entladen, die zu den Batteriezellen (3, 4, 5, 6, 7) parallel geschaltet sind, bis für die Zellspannung $U_l$ gilt: $U_l = U_{min}$,

    wobei die Schritte a) bis h) so oft in Zyklen wiederholt werden, bis die Differenz $U_{max}-U_{min}$ kleiner oder gleich ist als ein vorgegebener Grenzwert $\Delta U_1$ und es gilt Umax-Umin $\leq \Delta U_1$.

2.  Verfahren nach Anspruch 1, **dadurch gekennzeichnet, dass** bei Erreichen der vorgegebenen Ladeschlussspannung $U_{iL}$ der Batteriezelle i (3, 4, 5, 6, 7) durch die Reduktion des Ladestroms auf $I_i$ beim Aufladen des Energiespeichers (1) von konstantem Strom, auch genannt Constant Currant CC, umgeschaltet wird auf konstante Zellspannung der Batteriezelle i (3, 4, 5, 6, 7), auch genannt Constant Cell Voltage CCV.

3.  Verfahren nach einem der vorhergehenden Ansprüche, **dadurch gekennzeichnet, dass** für den vorgegebenen Spannungswert $\Delta U_1$ gilt:

    $$5mV \leq \Delta U_1 \leq 10mV.$$

4.  Verfahren nach einem der vorhergehenden Ansprüche, **dadurch gekennzeichnet, dass** für alle J Batteriezellen (3, 4, 5, 6, 7) die vorgegebene Ladeschlussspannung $U_{n,L}$ gleich ist und es gilt $U_{n,L} = U_{n+1,L}$ für $1 \leq n \leq J-1$.

5.  Verfahren nach einem der vorhergehenden Ansprüche, **dadurch gekennzeichnet, dass** der Ladestrom-Schwellenwert Isw für alle Batteriezellen gleich ist.

6.  Verfahren nach einem der Ansprüche 1 bis 4, **dadurch gekennzeichnet, dass** für jede Batteriezelle (3, 4, 5, 6, 7) der Ladestrom-Schwellenwert $I_{SW,n}$ vorgegeben ist in Abhängigkeit von einem jeder Batteriezelle zugeordneten maximalen Ladestrom $I_{n,max}$, und dass für den Ladestrom-Schwellenwert

$I_{SW,n}$ gilt: $0{,}01\, I_{n,max} \le I_{SW,n} \le 0{,}02\, I_{n,max}$ mit $1 \le n \le J$.

7. Verfahren nach einem der vorhergehenden Ansprüche, **dadurch gekennzeichnet, dass** für jede Batteriezelle (3, 4, 5, 6, 7) der reduzierte Ladestrom $I_n$ zwischen 1% und 2% des Ladestroms $I_0$ beträgt und es gilt $0{,}01\, I_0 \le I_n \le 0{,}02\, I_0$.

8. Verfahren nach einem der vorhergehenden Ansprüche, **dadurch gekennzeichnet, dass** für alle J Batteriezellen (3, 4, 5, 6, 7) nach dem Laden des Zellblocks (2), wobei alle J Batteriezellen (3, 4, 5, 6, 7) die gleiche Ladeschlussspannung $U_{n,L}$ aufweisen, die Kapazität $C_n$ mit $1 \le n \le J$ wie folgt bestimmt wird:

- alle J Batteriezellen (3, 4, 5, 6, 7) werden mit dem Entladestrom $I_0'$ entladen,
- sobald eine Batteriezelle p (3, 4, 5, 6, 7) mit $1 \le p \le J$ ihre vorgegebene Entladeschlussspannung $U_{p,E}$ erreicht, wird die Entladung aller Batteriezellen (3, 4, 5, 6, 7) gestoppt und es wird die Zeit $t_E$ vom Beginn der Entladung bis zum Ende der Entladung bestimmt,
- anschließend wird zu jeder Batteriezelle (3, 4, 5, 6, 7) die Zellspannung $U_n(t_E)$ mit $1 \le n \le J$ zum Zeitpunkt $t_E$ bestimmt,
- zu der Batteriezelle p (3, 4, 5, 6, 7), welche als erste ihre vorgegebene Entladeschlussspannung $U_{p,E}$ erreicht hat, wird aus der Zeit $t_E$, dem Entladestrom $I_0'$, der Ladeschlussspannung $U_{p,L}$ und der Zellspannung $U_p(t_E) = U_{p,E}$ die Kapazität $C_p$ bestimmt,
- zu der Batteriezelle p (3, 4, 5, 6, 7) wird die Zellspannung zwischen dem Beginn der Entladung und dem Ende der Entladung in Abhängigkeit von der Zeit als Spannungs-Zeit-Kurve vorgegeben,
- auf dieser Spannungs-Zeit-Kurve werden den Zellspannungen $U_n(t_E)$ aller Batteriezellen Zeiten $t_n$ zugeordnet, für die gilt $U_n(t_E) = U_p(t_n)$,
- aus den Zeiten $t_n$ und der Kapazität $C_p$ wird für alle verbleibenden $J-1$ Batteriezellen (3, 4, 5, 6, 7) ihre Kapazität $C_n$ bestimmt, die diese beim Erreichen ihrer vorgegebenen Entladeschlussspannung $U_{n,E}$ aufweisen.

9. Verfahren nach Anspruch 8, **dadurch gekennzeichnet, dass** die Zellspannung $U_n$ aller J Batteriezellen (3, 4, 5, 6, 7) beim Entladen erfasst wird, wobei die Erfassung kontinuierlich oder in vorgegebenen Zeitabständen erfolgt, und dass die erfasste Zellspannung $U_n$ jeder Batteriezelle (3, 4, 5, 6, 7) mit der für diese Batteriezelle vorgegebenen Entladeschlussspannung $U_{n,E}$ verglichen wird.

10. Verfahren nach Anspruch 8 oder 9, **dadurch gekennzeichnet, dass** zu allen Batteriezellen (3, 4, 5, 6, 7) beim Entladen die Zellspannung in Abhängigkeit von der Zeit erfasst wird, und dass für alle Batteriezellen (3, 4, 5, 6, 7) die Zellspannung in Abhängigkeit von der Zeit als Spannungs-Zeit-Kurve abgespeichert wird.

11. Verfahren nach einem der Ansprüche 8 bis 10, **dadurch gekennzeichnet, dass** die Kapazität $C_n$ der J Batteriezellen in bestimmten Zeitabständen bestimmt wird und in einem Speicher abgespeichert wird.

12. Verfahren nach einem der Ansprüche 8 bis 11, **dadurch gekennzeichnet, dass** für jede Batteriezelle ihre initiale Kapazität $C_{n,initial}$ mit $1 \le n \le J$ vorgegeben ist, wobei die initiale Kapazität $C_{n,initial}$ diejenige Kapazität ist, die die Batteriezelle vor der Erstinbetriebnahme aufweist, und dass für jede Batteriezelle in bestimmten Zeitabständen aus der Kapazität $C_n$ und der initialen Kapazität $C_{n,initial}$ der Zustand State of Health SoH der Batteriezelle bestimmt wird mit $SoH = C_n / C_{n,initial} * 100$.

**Claims**

1. Method for charging an energy store (1) with a charging current, wherein the energy store (1) comprises at least one cell block (2) having a number J of series-connected battery cells (3, 4, 5, 6, 7), of which at least some of the battery cells (3, 4, 5, 6, 7) may have different capacities $C_n$, different internal resistances and/or different efficiencies, where $1 \le n \le J$, with the following method steps:

a) charging all J battery cells (3, 4, 5, 6, 7) with a charging current $I_0$,
b) recording the cell voltage $U_n$ of all J battery cells (3, 4, 5, 6, 7), whereby the recording is carried out continuously or at predetermined time intervals,
c) comparing the recorded cell voltage $U_n$ of each battery cell (3, 4, 5, 6, 7) with the predetermined end-of-charge voltage $U_{n,L}$ specified for this battery cell,
d) as soon as a battery cell i (3, 4, 5, 6, 7) with $1 \le i \le J$ reaches a predetermined end-of-charge voltage $U_{i,L}$ for this battery cell i (3, 4, 5, 6, 7), the charging current for all battery cells (3, 4, 5, 6, 7) is reduced to a value $I_i$ for which the following applies

$$0A < I_i < I_0$$

whereby $I_i$ is a predetermined charging current for this battery cell i (3, 4, 5, 6, 7), at which the cell voltage Ui of battery cell i (3, 4, 5, 6, 7) does not rise above the end-of-charge voltage $U_{i,L}$, while all battery cells (3, 4, 5, 6, 7) continue to be charged with the charging current $I_i$,

e) as soon as during charging of the battery cells (3, 4, 5, 6, 7) with the charging current $I_i$, another battery cell j reaches its predetermined end-of-charge voltage, the charging current is further reduced to a charging current $I_j$ with $1 \leq j \leq J$ and $j \neq i$ and $I_j < I_i$,

f) as soon as the reduced charging current $I_i$ or $I_j$ is less than a specified charging current threshold value Isw, the charging current is switched off for all battery cells (3, 4, 5, 6, 7) and the cell voltage $U_n$ is determined for each battery cell (3, 4, 5, 6, 7) with $1 \leq n \leq J$,

g) the battery cell m (3, 4, 5, 6, 7) with the lowest cell voltage $U_m = U_{min}$ is determined and the battery cell l (3, 4, 5, 6, 7) with the highest cell voltage $U_l = U_{max}$ is determined,

h) with exception of the battery cell m (3, 4, 5, 6, 7), all other battery cells (3, 4, 5, 6, 7) are discharged via resistors (8, 9, 10, 11, 12) which are connected in parallel with the battery cells (3, 4, 5, 6, 7) until for the cell voltage $U_l$ the following applies: $U_l = U_{min}$

whereby the steps a) to h) are repeated in cycles until the difference $U_{max} - U_{min}$ is less than or equal to a predetermined limit value $\Delta_{U1}$ and $U_{max} - U_{min} \leq \Delta_{U1}$ applies.

2. Method according to claim 1, **characterized in that** when the predetermined end-of-charge voltage $U_{iL}$ of the battery cell i (3, 4, 5, 6, 7) is reached through the reduction of the charging current to $I_i$ during charging of the energy store (1), a switchover from constant current, also referred to as constant currant CC, to constant cell voltage of the battery cell i (3, 4, 5, 6, 7), also referred to as constant cell voltage CCV, occurs.

3. Method according to one of the preceding claims, **characterized in that** for the predetermined voltage value $\Delta_{U1}$ the following applies: $5mV \leq \Delta U_1 \leq 10mV$.

4. Method according to one of the preceding claims, **characterized in that** the predetermined end-of-charge voltage $U_{n,L}$ is the same for all J battery cells (3, 4, 5, 6, 7) and the following applies: $U_{n,L} = U_{n+1,L}$ for $1 \leq n \leq J-1$.

5. Method according to one of the preceding claims, **characterized in that** the charging current threshold Isw is the same for all battery cells.

6. Method according to one of claims 1 to 4, **characterized in that** for each battery cell (3, 4, 5, 6, 7) the charging current threshold value $I_{SW,n}$ is predetermined as a function of a maximum charging current $I_{n,max}$ assigned to each battery cell, and that for the charging current threshold value $I_{SW,n}$ the following

applies: $0.01\,I_{n,max} \leq I_{SW,n} \leq 0.02\,I_{n,max}$ with $1 \leq n \leq J$.

7. Method according to one of the preceding claims, **characterized in that** for each battery cell (3, 4, 5, 6, 7) the reduced charging current $I_n$ is between 1% and 2% of the charging current $I_0$ the following applies: $0.01\,I_0 \leq I_n \leq 0.02\,I_0$.

8. Method according to one of the preceding claims, **characterized in that** for all J battery cells (3, 4, 5, 6, 7) after charging the cell block (2), all J battery cells (3, 4, 5, 6, 7) having the same end-of-charge voltage $U_{n,L}$, the capacity $C_n$ with $1 \leq n \leq J$ is determined as follows:

- all J battery cells (3, 4, 5, 6, 7) are discharged with the discharge current $I_{0'}$,
- as soon as a battery cell p (3, 4, 5, 6, 7) with $1 \leq p \leq J$ reaches its specified end-of-discharge voltage $U_{p,E}$, the discharge of all battery cells (3, 4, 5, 6, 7) is stopped and the time $t_E$ from the start of discharge to the end of discharge is determined,
- then the cell voltage $U_n (t_E)$ is determined for each battery cell (3, 4, 5, 6, 7) with $1 \leq n \leq J$ at time $t_E$,
- for the battery cell p (3, 4, 5, 6, 7), which is the first to reach its specified end-of-discharge voltage $U_{p,E}$, the capacity $C_p$ is determined from the time $t_E$, the discharge current $I_{0'}$, the end-of-charge voltage $U_{p,L}$ and the cell voltage $U_p (t_E) = U_{p,E}$,
- for the battery cell p (3, 4, 5, 6, 7), the cell voltage between the start of discharge and the end of discharge is given as a voltage-time curve as a function of time,
- on this voltage-time curve, the cell voltages $U_n (t_E)$ of all battery cells are assigned times $t_n$, for which $U_n (t_E) = U_p (t_n)$ applies,
- from the times $t_n$ and the capacity $C_p$, the capacity $C_n$ of all the remaining J-1 battery cells (3, 4, 5, 6, 7) is determined, which they have when their predetermined end-of-discharge voltage $U_{n,E}$ is reached.

9. Method according to claim 8, **characterized in that** the cell voltage $U_n$ of all J battery cells (3, 4, 5, 6, 7) is recorded during discharge, whereby the recording is carried out continuously or at predetermined time intervals, and **in that** the recorded cell voltage $U_n$ of each battery cell (3, 4, 5, 6, 7) is compared with the predetermined end-of-discharge voltage $U_{n,E}$ for this battery cell.

10. Method according to claim 8 or 9, **characterized in that** the cell voltage is recorded as a function of time for all battery cells (3, 4, 5, 6, 7) during discharging, and **in that** the cell voltage is stored as a function of time as a voltage-time curve for all battery cells (3, 4, 5, 6, 7).

11. Method according to one of claims 8 to 10, **characterized in that** the capacity Cn of the J battery cells is determined at specific time intervals and is stored in a memory.

12. Method according to one of claims 8 to 11, **characterized in that** for each battery cell its initial capacity $C_{n,initial}$ is predetermined as $1 \le n \le J$, whereby the initial capacity $C_{n,initial}$ is the capacity which the battery cell has before initial commissioning, and that for each battery cell the state of health SoH of the battery cell is determined at specific time intervals from the capacity Cn and the initial capacity $C_{n,initial}$ with SoH = Cn/ $C_{n,initial}$ * 100.

**Revendications**

1. Procédé pour le chargement d'un accumulateur d'énergie (1) avec un courant de charge, dans lequel l'accumulateur d'énergie (1) présente au moins un bloc de cellules (2) comportant un nombre J de cellules de batterie (3, 4, 5, 6, 7) montées en série, dont au moins certaines des cellules de batterie (3, 4, 5, 6, 7) peuvent présenter des capacités $C_n$ différentes, des résistances internes différentes et/ou des rendements différents avec $1 \le n \le J$, comportant les étapes de procédé suivantes:

a) charge de toutes les J cellules de batterie (3, 4, 5, 6, 7) avec un courant de charge $I_0$,
b) détection de la tension de cellule $U_n$ de toutes les J cellules de batterie (3, 4, 5, 6, 7), dans lequel la détection est effectuée en continu ou à des intervalles prédéfinis,
c) comparaison de la tension de cellule $U_n$ détectée de chaque cellule de batterie (3, 4, 5, 6, 7) avec la tension de fin de charge $U_{n,L}$ prédéfinie pour ladite cellule de batterie,
d) dès qu'une cellule de batterie i (3, 4, 5, 6, 7) avec $1 \le i \le J$ atteint une tension de fin de charge $U_{i,L}$ prédéfinie pour ladite cellule de batterie i (3, 4, 5, 6, 7), le courant de charge est réduit pour toutes les cellules de batterie (3, 4, 5, 6, 7) à une valeur $I_i$ pour laquelle $0A < I_i < I_0$ dans lequel $I_i$ est un courant de charge prédéfini pour ladite cellule de batterie i (3, 4, 5, 6, 7), courant de charge dans lequel la tension de cellule Ui de la cellule de batterie i (3, 4, 5, 6, 7) n'augmente pas au-delà de la tension de fin de charge $U_{i,L}$, tandis que toutes les cellules de batterie (3, 4, 5, 6, 7) continuent à être chargées avec le courant de charge $I_i$,
e) dès que, lors de la charge des cellules de batterie (3, 4, 5, 6, 7) avec le courant de charge $I_i$,

une autre cellule de batterie j atteint sa tension de fin de charge prédéfinie, le courant de charge est davantage réduit à un courant de charge $I_j$ avec $1 \le j \le J$ et $j \ne i$ et $I_j < I_i$,
f) dès que le courant de charge réduit $I_i$ ou $I_j$ est inférieur à une valeur seuil de courant de charge Isw prédéfinie, le courant de charge est coupé pour toutes les cellules de batterie (3, 4, 5, 6, 7) et la tension de cellule $U_n$ est déterminée avec $1 \le n \le J$ pour chaque cellule de batterie (3, 4, 5, 6, 7),
g) la cellule de batterie m (3, 4, 5, 6, 7) est déterminée avec la plus petite tension de cellule $U_m = U_{min}$ et la cellule de batterie I (3, 4, 5, 6, 7) est déterminée avec la plus grande tension de cellule $U_I$ = Umax,
h) à l'exception de la cellule de batterie m (3, 4, 5, 6, 7), toutes les autres cellules de batterie (3, 4, 5, 6, 7) sont déchargées par l'intermédiaire de résistances (8, 9, 10, 11, 12) qui sont montées en parallèle avec les cellules de batterie (3, 4, 5, 6, 7), jusqu'à ce que la tension de cellule $U_I$ soit : $U_I = U_{min}$,

dans lequel les étapes a) à h) sont répétées en cycles jusqu'à ce que la différence $U_{max} - U_{min}$ soit inférieure ou égale à une valeur limite $\Delta U_1$ prédéfinie et que Umax - Umin $\le \Delta U_1$.

2. Procédé selon la revendication 1, **caractérisé en ce que**, lorsque la tension de fin de charge $U_{iL}$ prédéfinie de la cellule de batterie i (3, 4, 5, 6, 7) est atteinte, une commutation d'un courant constant, également appelé constant currant CC, à une tension de cellule constante, également appelé constant cell voltage CCV de la cellule de batterie i (3, 4, 5, 6, 7), est effectuée par la réduction du courant de charge à $I_i$ lors de la charge de l'accumulateur d'énergie (1).

3. Procédé selon l'une des revendications précédentes, **caractérisé en ce que**, pour la valeur de tension, $\Delta U_1$ prédéfinie suivantes s'appliquent: 5 mV $\le \Delta U_1 \le$ 10 mV.

4. Procédé selon l'une des revendications précédentes, **caractérisé en ce que**, pour toutes les J cellules de batterie (3, 4, 5, 6, 7), la tension de fin de charge $U_{n,L}$ prédéfinie est identique et $U_{n,L} = U_{n+1,L}$ pour $1 \le n \le J$ - 1.

5. Procédé selon l'une des revendications précédentes, **caractérisé en ce que** la valeur seuil de courant de charge Isw est identique pour toutes les cellules de batterie.

**6.** Procédé selon l'une des revendications 1 à 4, **caractérisé en ce que**, pour chaque cellule de batterie (3, 4, 5, 6, 7), la valeur seuil de courant de charge $I_{SW,n}$ est prédéfinie en fonction d'un courant de charge maximal $I_{n,max}$ associé à chaque cellule de batterie, et **en ce que**, pour la valeur seuil de courant de charge $I_{SW,n}$ suivantes s'appliquent: $0,01\ I_{n,max} \leq I_{SW,n} \leq 0,02\ I_{n,max}$ avec $1 \leq n \leq J$.

**7.** Procédé selon l'une des revendications précédentes,
**caractérisé en ce que**, pour chaque cellule de batterie (3, 4, 5, 6, 7), le courant de charge réduit $I_n$ est compris entre 1 % et 2 % du courant de charge $I_0$ et $0,01\ I_0 \leq I_n \leq 0,02\ I_0$.

**8.** Procédé selon l'une des revendications précédentes,
**caractérisé en ce que**, pour toutes les J cellules de batterie (3, 4, 5, 6, 7) après la charge du bloc de cellules (2), dans lequel toutes les J cellules de batterie (3, 4, 5, 6, 7) présentent la même tension de fin de charge $U_{n,L}$, la capacité $C_n$ est déterminée avec $1 \leq n \leq J$ comme suit:

  - toutes les J cellules de batterie (3, 4, 5, 6, 7) sont déchargées avec le courant de décharge $I_0'$,
  - dès qu'une cellule de batterie p (3, 4, 5, 6, 7) avec $1 \leq p \leq J$ atteint sa tension de fin de décharge $U_{p,E}$ prédéfinie, la décharge de toutes les cellules de batterie (3, 4, 5, 6, 7) est arrêtée et le temps $t_E$ entre le début de la décharge et la fin de la décharge est déterminé,
  - ensuite, pour chaque cellule de batterie (3, 4, 5, 6, 7), la tension de cellule $U_n\ (t_E)$ est déterminée avec $1 \leq n \leq J$ au moment $t_E$,
  - vers la cellule de batterie p (3, 4, 5, 6, 7) qui a atteint en premier sa tension de fin de décharge $U_{p,E}$ prédéfinie, la capacité $C_p$ est déterminée à partir du temps $t_E$, du courant de décharge $I_0'$, de la tension de fin de charge $U_{p,L}$ et de la tension de cellule $U_p\ (t_E) = U_{p,E}$,
  - vers la cellule de batterie p (3, 4, 5, 6, 7), la tension de cellule entre le début de la décharge et la fin de la décharge est prédéfinie en fonction du temps sous forme de courbe tension-temps,
  - sur ladite courbe tension-temps, les tensions de cellule $U_n\ (t_E)$ de toutes les cellules de batterie sont associées à des temps $t_n$ pour lesquels $U_n(t_E) = U_p(t_n)$,
  - à partir des temps $t_n$ et de la capacité $C_p$, pour toutes les J - 1 cellules de batterie (3, 4, 5, 6, 7) restantes, leur capacité $C_n$ est déterminée, lesquelles sont présentées par lesdites cellules de batterie lorsque leur tension de fin de décharge $U_{n,E}$ prédéfinie est atteinte.

**9.** Procédé selon la revendication 8, **caractérisé en ce que** la tension de cellule $U_n$ de toutes les J cellules de batterie (3, 4, 5, 6, 7) est détectée lors de la décharge, dans lequel la détection est effectuée en continu ou à des intervalles prédéfinis, et **en ce que** la tension de cellule $U_n$ détectée de chaque cellule de batterie (3, 4, 5, 6, 7) est comparée à la tension de fin de décharge $U_{n,E}$ prédéfinie pour ladite cellule de batterie.

**10.** Procédé selon la revendication 8 ou 9, **caractérisé en ce que**, pour toutes les cellules de batterie (3, 4, 5, 6, 7), la tension de cellule est détectée en fonction du temps lors de la décharge, et **en ce que**, pour toutes les cellules de batterie (3, 4, 5, 6, 7), la tension de cellule est enregistrée en fonction du temps sous forme de courbe tension-temps.

**11.** Procédé selon l'une des revendications 8 à 10, **caractérisé en ce que** la capacité $C_n$ des J cellules de batterie est déterminée à des intervalles déterminés et est enregistrée dans une mémoire.

**12.** Procédé selon l'une des revendications 8 à 11, **caractérisé en ce que**,

  pour chaque cellule de batterie, sa capacité initiale $C_{n,initial}$ est prédéfinie avec $1 \leq n \leq J$, dans lequel la capacité initiale $C_{n,initial}$ est la capacité que présente la cellule de batterie avant la première mise en service,
  et **en ce que**, pour chaque cellule de batterie, l'état de santé, également appelé state of health SoH de la cellule de batterie, est déterminé à des intervalles déterminés à partir de la capacité $C_n$ et de la capacité initiale $C_{n,initial}$, avec $SoH = C_n / C_{n,initial} * 100$.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102017009850 A1
- DE 102019129415 B3